Europäisches Patentamt

European Patent Office

Office européen des brevets

(19)

(11) Publication number: **0 055 572**

**B1**

(12) **EUROPEAN PATENT SPECIFICATION**

(45) Date of publication of patent specification: **13.08.86**

(51) Int. Cl.⁴: **G 11 C 5/02**

(21) Application number: **81305984.7**

(22) Date of filing: **21.12.81**

(54) A semiconductor memory device.

(30) Priority: **26.12.80 JP 188934/80**

(43) Date of publication of application:
**07.07.82 Bulletin 82/27**

(45) Publication of the grant of the patent:
**13.08.86 Bulletin 86/33**

(84) Designated Contracting States:
**DE FR GB**

(56) References cited:
**US-A-4 216 489**

**IEEE TRANSACTIONS ON ELECTRON
DEVICES, vol. 26, no. 6, June 1979, pages
839-852, IEEE, New York, US V.L. RIDEOUT:
"One-device cells for dynamic random-access
memories: a tutorial"**

**IBM TECHNICAL DISCLOSURE BULLETIN, vol.
20, no. 11A, April 1978, pages 4295-4296, New
York, US K.L. ANDERSON: "Shared bit line
sensing for two-device cell"**

(73) Proprietor: **FUJITSU LIMITED
1015, Kamikodanaka Nakahara-ku
Kawasaki-shi Kanagawa 211 (JP)**

(72) Inventor: **Miyasaka, Kiyoshi
577-45, Iijima-cho Totsuka-ku
Yokohama-shi Kanagawa 244 (JP)**

(74) Representative: **Billington, Lawrence Emlyn
et al
HASELTINE LAKE & CO Hazlitt House 28
Southampton Buildings Chancery Lane
London WC2A 1AT (GB)**

(56) References cited:
**PATENTS ABSTRACTS OF JAPAN, vol. 6, no. 5
(P-97)883r, 13th January 1982,**

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

## Description

This invention relates to a semiconductor memory device formed in a substrate. It is particularly, but not exclusively, applicable to a random access memory arrangement for a semiconductor memory device, particularly to a I-MIS transistor −1-capacitor type semiconductor memory device which has improved integration density by employing folded bit lines.

The I-MOS or MIS transistor −1-capacitor type random access memory (RAM) is roughly classified, conventionally, into two types in dependence upon pairs of bit lines connected to sense amplifiers. The memory of the first type has the arrangement of the bit lines of the bit line pair extending outwardly at both right and left sides of the sense amplifier. The prior art reference U.S. Patent No. 4,012,757 discloses such a memory. The memory of the second type has the arrangement of the bit lines of the bit line pair extending in parallel with the sense amplifier in only one direction. The prior art reference U.S. Patent No. 4,044,340 discloses such a type of memory.

The RAM of 1-transistor −1-capacitor type comprises a plurality of memory cells having a capacitor for storing data and a transfer transistor for electrically making conductive such capacitor for the bit lines. Readout of data is carried out as explained below. Charges stored in the capacitors of selected memory cells are read out to the bit lines, a potential of the bit lines is amplified by the sense amplifier and then the signal obtained is read out to the outside via a bus line.

A RAM of this type is required to have capacitors having large capacitance for each memory in order to realize error-free readout of data and long refresh time. However, in cases where the memory has a large capacity, the capacitors tend to occupy less area. Therefore, it has been a contradictory requirement for the 1-transistor −1-capacitor type RAM to realize a large capacity of memory, error-free readout of data and long refresh time.

A preferred embodiment of the present invention may provide a semiconductor memory device having both large capacity and also a wide capacitor region in each memory cell. Also, it may provide a semiconductor memory device having a high capacitor region area efficiency, i.e. a high ratio of area of capacitor region to memory cell area.

According to the present invention there is provided a folded bit line type semiconductor memory device formed in a substrate, which device comprises:

a plurality of first and second word lines;

a plurality of sense amplifiers;

a plurality of pairs of bit lines, each pair of bit lines comprising first and second bit lines which are connected to a common sense amplifier and extend in parallel with each other from said sense amplifier; and

a plurality of memory cells, each respective memory cell comprising a storage capacitor, connected to crossing regions of bit and word lines, characterised in that:

the inward bit lines ($\bar{B}_0$, $\bar{B}_1$) of two adjacent pairs of bit lines ($B_0$, $\bar{B}_0$, $B_1$, $\bar{B}_1$) are each sandwiched between the adjacent pair of bit lines;

the memory cells are grouped in pairs ($C_0C_1$ to $C_6C_7$), each pair of memory cells shares a bit line, the cells ($C_0$, $C_1$) sharing a first ($B_0$) bit line of the first pair of bit lines ($B_0$, $\bar{B}_0$) and being offset by one word line pitch with respect to a pair of cells ($C_2$, $C_3$) sharing the second bit line ($\bar{B}_1$) of the second pair of bit lines, being offset by two word line pitches with respect to a pair of cells ($C_4$, $C_5$) sharing the second bit line ($\bar{B}_0$) of the first pair of bit lines ($B_0$, $\bar{B}_0$) and being offset by three word line pitches with respect to a pair of cells ($C_6C_7$) sharing the first bit line ($B_1$) of the second pair of bit lines ($B_1$, $\bar{B}_1$), this pattern of cells being repetitive, and the next pair of cells ($C_8$, $C_9$) connected to the first bit line ($B_0$) of the first pair of bit lines being at a distance of four word line pitches from the first pair of cells ($C_0$, $C_1$), the memory cells associated with one bit line being interleaved with the memory cells of the adjacent bit lines.

According to a development, each memory cell comprises a transfer transistor through which the storage capacitor is connected to the associated bit line, and a capacitor region at which the storage capacitor is disposed, in which device first capacitor regions corresponding to any one bit line are shifted with respect to second capacitor regions corresponding to a bit line adjacent to said any one bit line, the shift being in a direction parallel to the bit lines.

For a better understanding of the invention and to show how it may be put into effect reference will now be made by way of example to the accompanying drawings in which:

Fig. 1 is the plan view of a memory pattern of a conventional 1-transistor −1-capacitor type dynamic RAM;

Fig. 2 is the schematic diagram of the RAM shown in Fig. 1;

Fig. 3 is the plan view of a memory cell pattern of a conventional folded bit line type dynamic RAM;

Fig. 4 is the schematic diagram of the RAM shown in Fig. 3;

Fig. 5 is the plan view of the memory cell pattern of a preferred embodiment of RAM according to the present invention;

Fig. 6 is a sectional view of a memory cell of the RAM shown in Fig. 5;

Fig. 7 is the equivalent schematic diagram of the RAM shown in Fig. 5;

Fig. 8 is the plan view of the RAM shown in Fig. 5 in a production process; and

Fig. 9 is a sectional view of the RAM shown in Fig. 5 in the production process.

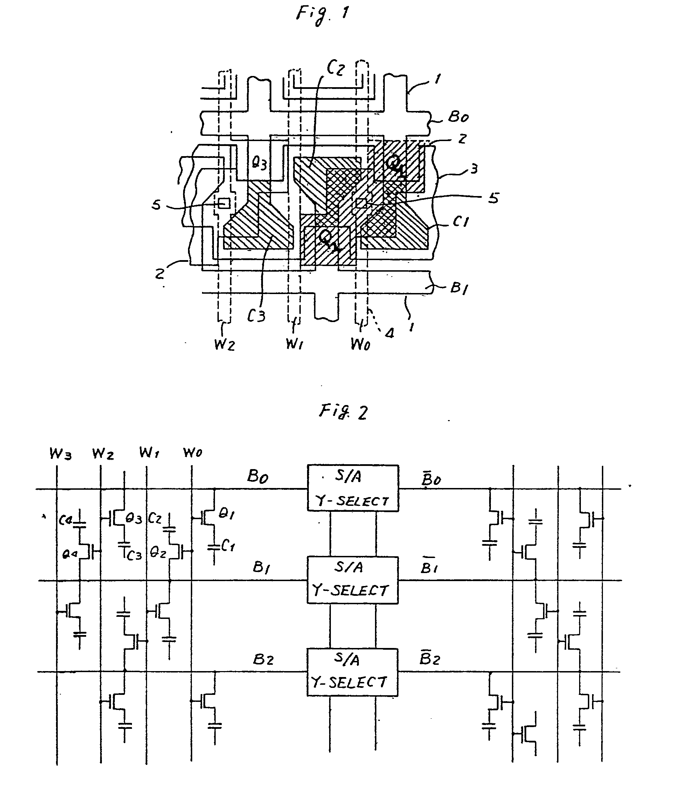

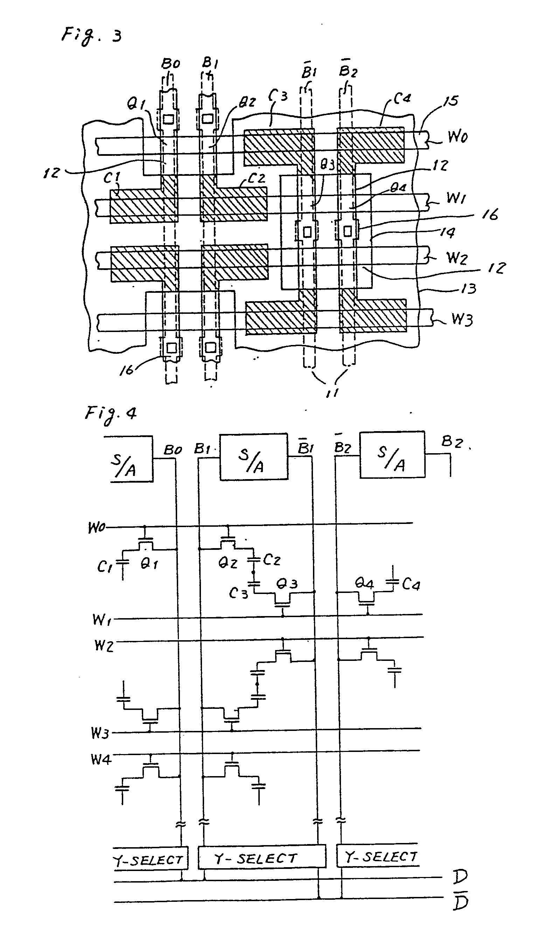

The plan views of memory cell patterns of conventional 1-transistor −1-capacitor type dynamic RAMs are shown in Fig. 1 and Fig. 3. The schematic diagrams respectively corresponding to Fig. 1 and Fig. 3 are also shown in Fig. 2 and Fig. 4.

The conventional RAM shown in Fig. 1 and Fig. 2 corresponds to the first type mentioned above and is generally called the open bit line type, wherein the bit line pairs $(B_0, \overline{B}_0)$, $(B_1, \overline{B}_1)$, $(B_2, \overline{B}_2)$, ... extend outwardly at both sides of the respective sense amplifiers S/A. Y SELECT is the column selection circuit, which selects the bit line pairs and connects the selected bit line pair to the data bus line (not illustrated). $Q_1, Q_2, Q_3, \ldots$ are transfer transistors; $C_1, C_2, C_3, \ldots$ are capacitors; and a l-bit memory cell is formed by $Q_i, C_i$ ($i=1, 2 \ldots$). $W_0, W_1, \ldots$ are word lines.

The readout operation for the memory cell $Q_1$, $C_1$ is carried out as explained below. Namely, the word line $W_0$ is set to the H level, the transistor $Q_1$ is turned ON and the potential of bit line $B_0$ is determined in accordance with the capacitance of capacitor $C_1$. Simultaneously, the potential of bit line $\overline{B}_0$ is determined in accordance with the capacitance of a capacitor of a dummy cell (not illustrated) connected to the bit line $\overline{B}_0$. A voltage difference between both bit lines $B_0$, $\overline{B}_0$ is detected by the top sense amplifier S/A and then amplified and finally transferred to the data bus line (not illustrated).

In the pattern of Fig. 1, the bit lines $B_0$, $B_1$, are basically formed by diffusion layers provided within the substrate. The capacitors $C_1, C_2 \ldots$ are composed of a first channel region (hatched from upper left to lower right). At the area between bit lines $B_0$, $B_1 \ldots$ and the capacitors $C_1, C_2 \ldots$, the transfer transistors $Q_1, Q_2 \ldots$ are provided and the transistor is composed of a second channel formation region where a second polycrystalline silicon layer 2 (hatched from upper right to lower left) is used as the gate electrode. One electrode of capacitors $C_1, C_2 \ldots$ is formed within the substrate, while the other electrode is formed by the first polycrystalline silicon layer 3. The word lines $W_0, W_1 \ldots$ are formed by the aluminium (Al) wiring layer 4 and connected to the polycrystalline silicon layer 2 of the gate electrode of the transistor via the contact hole 5.

The conventional RAM shown in Fig. 3 and Fig. 4 corresponds to the second type explained above. The bit line pairs $(B_0, \overline{B}_0)$, $(B_1, \overline{B}_1)$, $(B_2, \overline{B}_2)$, ... extend in parallel from the respective sense amplifier S/A. This second type is generally called the folded bit line type. $W_0, W_1, \ldots$ are word lines in pairs; Y-SELECT is the column selection circuit; D, $\overline{D}$ are data bus lines. Here, the readout operation and write operation are not explained because they are the same as those of said first type.

In Fig. 3, the bit lines $B_0, B_1, \ldots$ are formed by the aluminium wiring layer 11. The diffusion layers 12 provided within the substrate become the source and drain regions of transistors $Q_1, Q_2, \ldots$ The capacitors $C_1, C_2 \ldots$ are formed in the channel region (hatched from upper left to lower right). One electrode of the capacitor is composed of the substrate, while the other electrode is composed of the first polycrystalline silicon layer 13. The word lines $W_0, W_1 \ldots$ are composed of the second polycrystalline silicon layer 13. 16 is the contact hole which connects the bit line of aluminium wiring layer 11 and the diffusion layer 12 and is formed at the window 14 provided on the first polycrystalline silicon layer 13.

The layout system of a conventional dynamic RAM explained above has a low capacitor area efficiency, even in the design limit of the layout, namely a capacitor area ratio for the memory cell area of as low as 20 to 30%. An embodiment of the present invention is intended to improve the capacitor area efficiency and thereby to achieve high capacity of memory and high integration density.

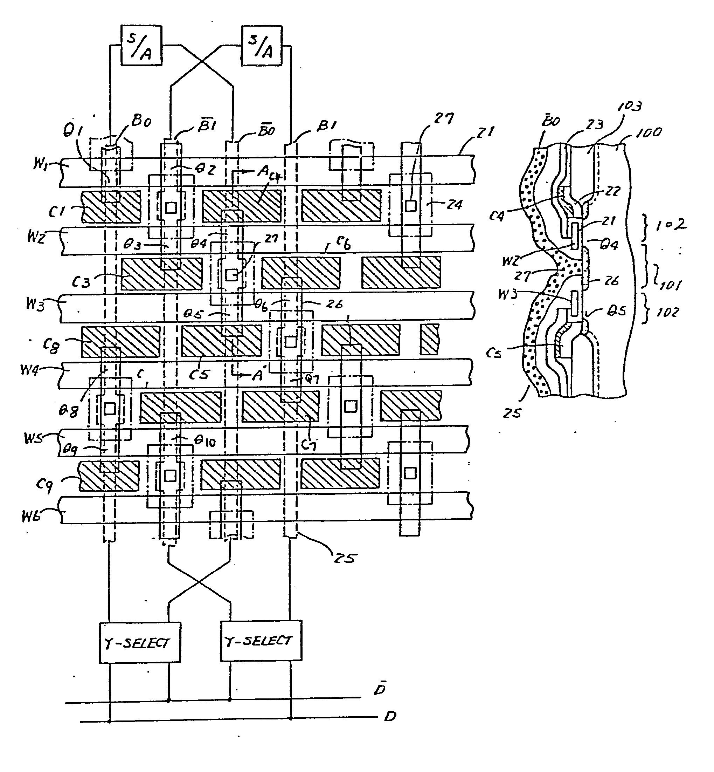

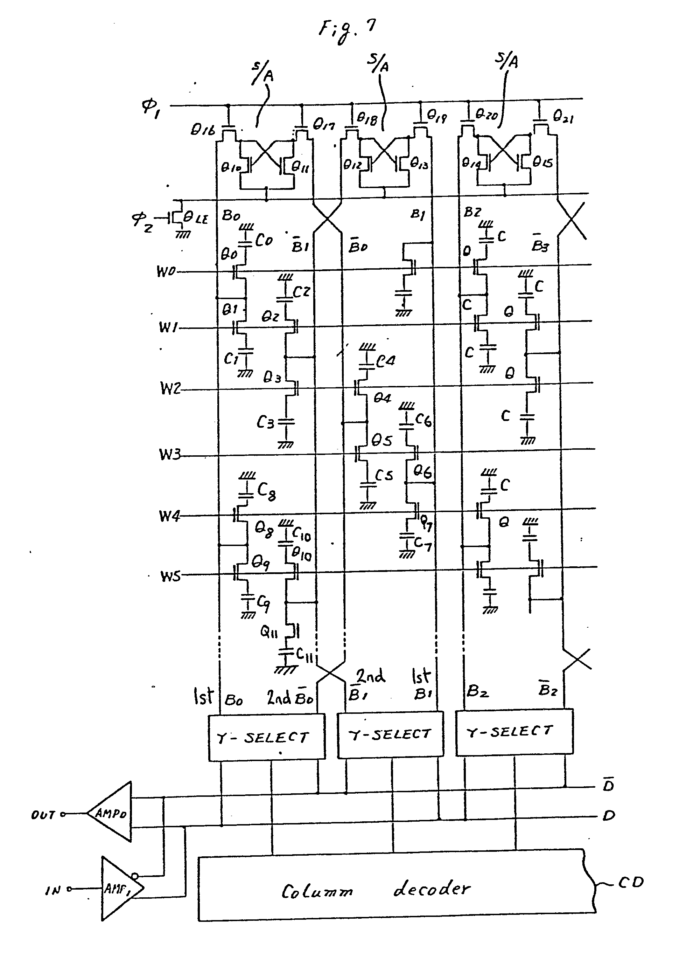

A preferred embodiment of the present invention is explained below. Fig. 5 is the plan view of the memory cell pattern of this embodiment. Fig. 6 is a sectional view along the line A—A' of Fig. 5 and Fig. 7 is the equivalent schematic diagram of Fig. 5. The same portions as the conventional ones are indicated by the same symbols.

As shown in Fig. 5 and Fig. 7, first of all in adjacent bit line pairs one bit line of one pair is provided between the bit lines of the other pair, see for example bit line pairs $(B_0, \overline{B}_0)$, $(B_1, \overline{B}_1)$. Secondly, as shown in Fig. 5, the capacitor region (hatched area) wherein the capacitors corresponding to the bit lines are formed is formed in such a manner that the capacitor regions of adjacent bit lines are shifted vertically with respect to one another. Also, they are mutually interleaved. For example, see the bit line $\overline{B}_1$ which exists between the bit lines $B_0$ and $\overline{B}_0$, and the capacitor regions associated with these respective bit lines.

As shown in Fig. 6, each memory cell comprises the contact region 101, transfer region 102 and capacitor regions $C_4, C_5$. In the contact region 101, the diffusion region 26 provided within the substrate 100 and the bit line $\overline{B}_0$, consisting of the aluminium wiring layer 25, are connected. At the transfer region 102, on the other hand, the word lines $W_2, W_3$ which are used as the gate electrode 21 are provided over the substrate 100 via the gate insulating film and thereby the MIS FET of transfer transistor is formed. It is to be noted that a structure of dual memory cells (plus the transfer transistors) in which the cells share a common bit line and are placed on either side of a pair of word lines is known from Figures 2 and 3 of US—A— 4 216 489.

Concerning the layout of the capacitor regions, the capacitor regions $C_1, C_3, C_4, C_5, C_6, C_7, C_8$ and $C_9$ are formed, for example, between the word lines $W_1, W_2, W_3, W_4$ and $W_5$. The capacitor regions $C_3, C_6$ corresponding to the adjacent bit lines $\overline{B}_1, B_1$ are provided between two word lines $W_2, W_3$ between the capacitor regions $C_4$ and $C_5$ corresponding to the bit lines $\overline{B}_0$.

Moreover, in the case of this embodiment, the memory cell consisting of $Q_4$ and $C_4$ and that consisting of $Q_5$ and $C_5$ are connected to the bit line $\overline{B}_0$ via the same contact region 101. The

5  0 055 572  6

memory cell pair of the same bit line $\overline{B}_0$ is provided adjacently via the two word lines $W_4$ and $W_5$ or $W_1$ and $W_4$. The capacitor regions $C_3$ and $C_6$ corresponding to the adjacent bit lines $\overline{B}_1$ and $B_1$ are provided between two word lines $W_2$ and $W_3$ of the memory cell pair.

In addition, the contact region of the adjacent bit lines are provided with a little positional deviation as much as one word line in order to prevent multiple selection. This is because if the bit lines $(B_0, \overline{B}_1)$ $(\overline{B}_0, B_1)$ are directly connected to the sense amplifier S/A as the bit line pair, an unwanted phenomenon occurs, namely, $(Q_1, C_1)$, $(Q_2, C_2)$ are selected simultaneously when the word line $W_1$ is selected. For this reason, the present embodiment of the present invention successfully eliminates such disadvantage by providing the one of the other bit line pair between the bit line pair.

In Fig. 7, each sense amplifier S/A consists of a flip-flop circuit where the gates and drains of the two transistors $(Q_{10}, Q_{11})$, $(Q_{12}, Q_{13})$, $(Q_{14}, Q_{15})$ are respectively cross-coupled. Each sense amplifier S/A is activated by a transistor $Q_{LE}$ which is controlled by a clock $\phi_2$. On the other hand, each sense amplifier S/A is connected to the associated bit line pair via the associated ones of transistors $Q_{16}$ to $Q_{21}$ which are controlled by the signal $\phi_1$. $\overline{D}$, D are data bus lines being connected to the output amplifier $AMP_0$ and input amplifier $AMP_1$. CD is a column decoder circuit which selects the column selection circuit Y-SELECT.

Referring back to Fig. 6, the memory cell of this embodiment utilizes three layers of polycrystalline silicon layer and a single metal (aluminium) layer. Namely, the first layer 21 is the word line; the second layer 22 is the first electrode of the capacitor; the third layer 23 is the common second electrode of the capacitor. The third layer 23 is formed continuously on the entire part. The metal layer 25 is the bit line.

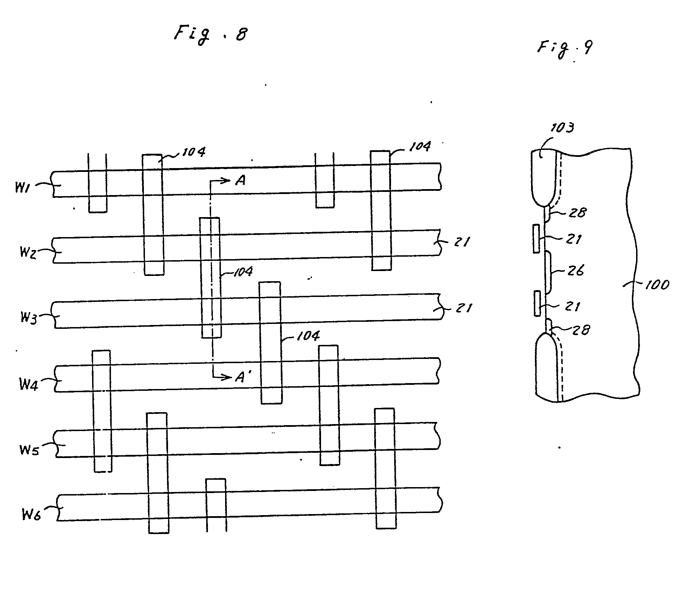

An example of a production method for this embodiment is explained below by referring to Figs. 6, 8 and 9.

The thick silicon oxide film 103 is formed at the surface of the monocrystalline silicon substrate 100, except for the area 104 indicated in the figure. Next, the word lines $W_1$, $W_2$ ... consisting of the polycrystalline silicon layer 21 of the first layer and the diffusion regions 26, 28 are formed.

Thereafter, the electrode consisting of the polycrystalline silicon layer 22 of the second layer is formed and is connected to the diffusion layer region 28, which is used as the first electrode extending on the thick oxide film 103. On this layer 22, the polycrystalline silicon layer 23 of the third layer is formed on the entire part of it via the dielectric layer and it is used as the second electrode of the capacitor. Therefore, this layer 23 is connected, for example, to the regulated power source such as the ground power supply. Then, the window 24 is provided at that area corresponding to the contact region of this layer 23. Finally, the aluminium wiring layer 25 is formed on the polycrystalline silicon layer 23 of the third layer and it is used as the bit line. This metal wiring layer 25 is connected to the diffusion region 26 at the contact region.

In the above embodiment, only one bit line of one pair of bit lines is provided between the bit lines of another pair, but the present invention also allows one bit line of a plurality of the other bit line pairs to exist between the bit lines of a bit line pair.

As explained previously, according to the present embodiment of the present invention, the capacitor regions $C_1$, $C_2$, ... of each memory are integrated effectively. Therefore, the area efficiency of the capacitors can be improved as high as about 40%. Thereby, a large capacity memory can be realized, readout operation can be stabilized and the interval of refresh time can be made long.

**Claims**

1. A folded bit line type semiconductor memory device formed in a substrate, which device comprises:

   a plurality of first and second word lines;
   a plurality of sense amplifiers;
   a plurality of pairs of bit lines, each pair of bit lines comprising first and second bit lines which are connected to a common sense amplifier and extend in parallel with each other from said sense amplifier; and
   a plurality of memory cells, each respective memory cell comprising a storage capacitor, connected to crossing regions of bit and word lines, characterised in that:

   the inward bit lines $(\overline{B}_0, \overline{B}_1)$ of two adjacent pairs of bit lines $(B_0, \overline{B}_0, B_1, \overline{B}_1)$ are each sandwiched between the adjacent pair of bit lines;

   the memory cells are grouped in pairs $(C_0C_1$ to $C_6C_7)$, each pair of memory cells shares a bit line, the cells $(C_0, C_1)$ sharing a first $(B_0)$ bit line of the first pair of bit lines $(B_0, \overline{B}_0)$ and being offset by one word line pitch with respect to a pair of cells $(C_2, C_3)$ sharing the second bit line $(\overline{B}_1)$ of the second pair of bit lines, being offset by two word line pitches with respect to a pair of cells $(C_4, C_5)$ sharing the second bit line $(\overline{B}_0)$ of the first pair of bit lines $(B_0, \overline{B}_0)$ and being offset by three word line pitches with respect to a pair of cells $(C_6C_7)$ sharing the first bit line $(B_1)$ of the second pair of bit lines $(B_1, \overline{B}_1)$, this pattern of cells being repetitive, and the next pair of cells $(C_8, C_9)$ connected to the first bit line $(B_0)$ of the first pair of bit lines being at a distance of four word line pitches from the first pair of cells $(C_0, C_1)$, the memory cells associated with one bit line being interleaved with the memory cells of the adjacent bit lines.

2. A semiconductor memory device according to claim 1, wherein each memory cell comprises a transfer transistor $(Q_0$ to $Q_7)$ through which the storage capacitor $(C_0$ to $C_7)$ is connected to the associated bit line $(B_0$ to $\overline{B}_1)$, and a capacitor region at which the storage capacitor is disposed, in which device first capacitor regions $(C_1, C_8, C_9)$

4

corresponding to any one bit line are shifted with respect to second capacitor regions $(C_3 \, C_{10})$ corresponding to a bit line adjacent to said any one bit line, the shift being in a direction parallel to the bit lines.

3. A semiconductor memory device according to any preceding claim, wherein said word lines orthogonally cross said bit lines and each memory cell comprises a contact region (101) at which the corresponding bit line (25) is electrically connected to a or the transfer transistor of the memory cell, and a transfer region (102), contiguous to said contact region (101), wherein is disposed the corresponding word line $(W_2)$, of which part is a gate electrode of said transfer transistor, a storage capacitor region $(C_4)$ being disposed contiguous to said transfer region (102), and in the device as a whole the capacitor regions $(C_4$ etc.) corresponding to a bit line (25) are disposed between the capacitor regions corresponding to a bit line adjacent to said bit line.

4. A semiconductor memory device according to claim 3, each memory cell pair having two memory cells and being connected to the corresponding bit line, said memory cell pair comprising:

a common contact region (101);

first and second transfer regions (102) disposed at both respective sides of said contact region (101);

first and second capacitor regions $(C_4, C_5)$ being contiguous to said first and second transfer regions (102) respectively;

wherein the memory cell pairs corresponding to any one bit line are adjacent to each other through two word lines, and a first or second capacitor region of said memory cell pair corresponding to said bit line adjacent to said bit line is disposed between word lines which are disposed respectively at first and second transfer regions of said memory cell pair corresponding to said any one bit line.

5. A semiconductor memory device according to claim 3 or 4 wherein said capacitor region comprises:

a diffusion region (28) in a substrate,

a first electrode layer (22) connected to said diffusion region (28) and extending over an insulation layer on said substrate, and

a second electrode layer (23) over said first electrode layer (22) through a dielectric layer.

6. A semiconductor memory device according to claim 5, wherein

the second electrode layers (23) are formed by a common conductive layer over said substrate, and

said common conductive layer comprises a hole (27) at a connecting region through which said bit line (25) over said common conductive layer is connected to a diffusion region (26) in said substrate of said connecting region.

7. A semiconductor memory device according to claim 6, wherein the word line is disposed under said common conducting layer.

8. A semiconductor memory device according to claim 5, 6 or 7, wherein said substrate comprises monocrystalline semiconductor, said word line and said first and second electrode layers comprise polycrystalline silicon, and said bit line comprises metal.

## Patentansprüche

1. In einem Substrat gebildete Halbleiterspeichervorrichtung vom Typ gefalteter Bitleitungen, welche Vorrichtung umfaßt:

eine Vielzahl von ersten und zweiten Wortleitungen;

eine Vielzahl von Leseverstärkern;

eine Vielzahl von Paaren von Bitleitungen, von denen jedes Bitleitungspaar eine erste und eine zweite Bitleitung umfaßt, die mit einem gemeinsamen Leseverstärker verbunden sind und sich parallel zueinander von dem Leseverstärker fort erstrecken; und

eine Vielzahl von Speicherzellen, von denen jede einen Speicherkondensator umfaßt, und die mit Kreuzungsbereichen der Bit- und Wortleitungen verbunden sind, dadurch gekennzeichnet, daß

die inneren Bitleitungen $(\overline{B}_0, \, \overline{B}_1)$ von benachbarten Paaren von Bitleitungen $(B_0, \, \overline{B}_0, \, B_1, \, \overline{B}_1)$ zwischen dem benachbarten Paar von Bitleitungen eingebettet sind;

die Speicherzellen in Paaren $(C_0C_1$ bis $C_6C_7)$ gruppiert sind, von denen jedes Paar von Speicherzellen eine Bitleitung gemeinsam benutzt, die Zellen $(C_0, \, C_1)$ eine erste $(B_0)$ Bitleitung des ersten Paares von Bitleitungen $(B_0, \, \overline{B}_0)$ gemeinsam benutzt und um eine Wortleitungsteilung bezüglich einem Paar von Zellen $(C_2, \, C_3)$ versetzt ist, welches die zweite Bitleitung $(\overline{B}_1)$ des zweiten Paares von Bitleitungen gemeinsam benutzt, und um zwei Wortleitungsteilungen bezüglich einem Paar von Zellen $(C_4, \, C_5)$ versetzt ist, welches die zweite Bitleitung $(\overline{B}_0)$ der ersten Paares von Bitleitungen $(B_0, \, \overline{B}_0)$ gemeinsam benutzt, und um drei Wortleitungsteilungen gegenüber einem Paar von Zellen $(C_6C_7)$, das die erste Bitleitung $(B_1)$ des zweiten Bitleitungspaares $(B_1, \, \overline{B}_1)$ gemeinsam benutzt, versetzt ist, wobei dieses Muster von Zellen sich wiederholt, und das nächste Paar von Zellen $(C_8, \, C_9)$, das mit der ersten Bitleitung $(B_0)$ des ersten Paares von Bitleitungen verbunden ist, in einem Abstand von vier Wortleitungsteilungen von dem ersten Paar von Zellen $(C_0, \, C_1)$ entfernt ist, wobei die Speicherzellen, die einer Bitleitung zugeordnet sind, mit den Speicherzellen der benachbarten Bitleitungen verschachtelt sind.

2. Halbleiterspeichervorrichtung nach Anspruch 1, bei welcher jede Speicherzelle einen Transfertransistor $(Q_0$ bis $Q_7)$ umfaßt, durch welchen der Speicherkondensator $(C_0$ bis $C_7)$ mit der zugeordneten Bitleitung $(B_0$ bis $\overline{B}_1)$ verbunden ist, und einen Kondensatorbereich, in dem der Speicherkondensator angeordnet ist, bei welcher Vorrichtung erste Kondensatorbereiche $(C_1, \, C_8, \, C_9)$, die irgendeiner Bitleitung entsprechen, bezüglich der zweiten Kondensatorbereiche $(C_3,$

$C_{10}$), die einer Bitleitung entsprechen, die der genannten beliebigen Bitleitung benachbart ist, verschoben sind, wobei die Verschiebung in einer Richtung parallel zu den Bitleitungen ist.

3. Halbleiterspeichervorrichtung nach einem der vorhergehenden Ansprüche, bei welcher die Wortleitungen orthogonal die genannten Bitleitungen kreuzen und jede Speicherzelle einen Kontaktbereich (101) umfaßt, bei welchem die entsprechende Bitleitung (25) elektrisch mit einem oder dem Transfertransistor der Speicherzelle verbunden ist, und einen Transferbereich (102), der an den genannten Kontaktbereich (101) angrenzt, in dem die entsprechende Wortleitung ($W_2$) angeordnet ist, von welchem eine Gateelektrode des genannten Transfertransistors ein Teil ist, einen Speicherkondensatorbereich ($C_4$), der an den Transferbereich (102) angrenzend angeordnet ist, und in der Vorrichtung als ganzer die Speicherbereiche ($C_4$ etc.), die einer Bitleitung (25) entsprechen, zwischen den Kondensatorbereichen angeordnet sind, die einer Bitleitung neben der genannten Bitleitung entsprechen.

4. Halbleiterspeichervorrichtung nach Anspruch 3, bei welcher jedes Speicherzellenpaar zwei Speicherzellen hat und mit der entsprechenden Bitleitung verbunden ist, bei welcher das genannte Speicherzellenpaar umfaßt:
einen gemeinsamen Kontaktbereich (101);
erste und zweite Transferbereiche (102), die zu beiden entsprechenden Seiten des genannten Kontaktbereiches (101) angeordnet sind;
erste und zweite Kondensatorbereiche ($C_4$, $C_5$), die an die ersten bzw. zweiten Transferbereiche (102) angrenzend ausgebildet sind;
bei welcher die Speicherzellenpaare, die irgendeiner Bitleitung entsprechen, einander über zwei Wortleitungen benachbart sind, und eine erster oder zweiter Kondensatorbereich des genannten Speicherzellenpaares, welches der genannten Bitleitung neben der genannten Bitleitung entspricht, zwischen Wortleitungen angeordnet ist, die jeweils bei ersten und zweiten Transferbereichen des genannten Speicherzellenpaares angeordnet sind, welches der genannten beliebigen einen Bitleitung entspricht.

5. Halbleiterspeichervorrichtung nach Anspruch 3 oder 4, bei welcher der genannte Kondensatorbereich einen Diffusionsbereich (28) in einem Substrat umfaßt, und einer erste Elektrodenschicht (22), die mit dem genannten Diffusionsbereich (28) verbunden ist und sich über einer Isolationsschicht auf dem genannten Substrat erstreckt, und eine zweite Elektrodenschicht (23) über der genannten ersten Elektrodenschicht (22), mit einer dielektrischen Schicht dazwischen.

6. Halbleiterspeichervorrichtung nach Anspruch 5, bei welcher die zweiten Elektrodenschichten (23) durch eine gemeinsame leitende Schicht über dem genannten Substrat gebildet sind, und die genannte gemeinsame leitende Schicht ein Loch (27) in einm Verbindungsbereich umfaßt, durch welches die genannte Bitleitung (25) über der gemeinsamen leitenden Schicht mit einem Diffusionsbereich (26) in dem genannten Substrat des genannten Verbindungsbereiches verbunden ist.

7. Halbleiterspeichervorrichtung nach Anspruch 6, bei welcher die Wortleitung unter der genannten gemeinsamen leitenden Schicht angeordnet ist.

8. Halbleiterspeichervorrichtung nach Anspruch 5, 6 oder 7, bei welcher das genannte Substrat einen monokristallinen Halbleiter umfaßt, die genannte Wortleitung und die genannten ersten und zweiten Elektrodenschichten polykristallines Silizium umfassen und die genannte Bitleitung Metall umfaßt.

**Revendications**

1. Dispositif de mémoire à semi-conducteur du type à fils de bit pliés formé dans un substrat, ce dispositif comprenant:

— un ensemble de premiers et seconds fils de mot;
— un ensemble d'amplificateurs de détection;
— un ensemble de paires de fils de bit, chaque paire de fils de bit comprenant des premier et second fils de bit qui sont connectés à un amplificateur de détection commun et s'étendent parallèlement entre eux à partir de l'amplificateur de détection; et
— un ensemble de cellules de mémoire, chaque cellule de mémoire respective comprenant un condensateur de stockage, connecté à des régions de croisement de fils de bit et de mot, caractérisé en ce que:
— les fils de bit vers l'intérieur ($\overline{B}_0$, $\overline{B}_1$) de deux paires voisines de fils de bit ($B_0$, $\overline{B}_0$, $B_1$, $\overline{B}_1$) sont chacun placés en sandwich entre la paire voisine de fils de bit;
— les cellules de mémoire sont groupées en paires ($C_0 C_1$ à $C_6 C_7$), chaque paire de cellules de mémoire partageant un fil de bit, les cellules ($C_0$, $C_1$) partageant un premier fil de bit ($B_0$) de la première paire de fils de bit ($B_0$, $\overline{B}_0$) et étant décalées d'un pas de fil de mot par rapport à une paire de cellules ($C_2$, $C_3$) partageant le second fil de bit ($\overline{B}_1$) de la deuxième paire de fils de bit, étant décalées de deux pas de fil de mot par rapport à une paire de cellules ($C_4$, $C_5$) partageant le second fil de bit ($\overline{B}_0$) de la première paire de fils de bit ($B_0$, $\overline{B}_0$) et étant décalées de trois pas de fil de mot par rapport à une paire de cellules ($C_6 C_7$) partageant le premier fil de bit ($B_1$) de la deuxième paire de fils de bit ($B_1$, $\overline{B}_1$), cette configuration de cellules étant répétitive, et la paire suivante de cellules ($C_8$, $C_9$) connectée au premier fil de bit ($B_0$) de la première paire de fils de bit étant à une distance de quatre pas de fil de mot de la première paire de cellules ($C_0$, $C_1$), les cellules de mémoire associées à un fil de bit étant imbriquées avec les cellules de mémoire des fils de bit voisins.

2. Dispositif de mémoire à semi-conducteur selon la revendication 1, caractérisé en ce que chaque cellule de mémoire comprend un transistor de transfert ($Q_0$ à $Q_7$) par lequel le condensateur de stockage ($C_0$ à $C_7$) est connecté au fil de bit associé ($B_0$ à $\bar{B}_1$), et une région de condensateur dans laquelle le condensateur de stockage est placé, des premières régions de condensateur ($C_1$, $C_8$, $C_9$) de ce dispositif correspondant à un fil de bit étant décalées par rapport à des secondes régions de condensateur ($C_3$, $C_{10}$) correspondant à un fil de bit voisin dudit fil de bit, le décalage étant dans une direction parallèle aux fils de bit.

3. Dispositif de mémoire à semi-conducteur selon l'une quelconque des revendications 1 et 2, caractérisé en ce que les fils de vot coupent orthogonalement les fils de bit et en ce que chaque cellule de mémoire comprend und région de contact (101) dans laquelle le fil de bit (25) correspondant est connecté électriquement à un ou au transistor de transfert de la cellule de mémoire, et une région de transfert (102), contiguë à la région de contact (101), dans laquelle est placé le fil de mot correspondant ($W_2$), une électrode de grille du transistor de transfert étant incluse dans cette partie, une région de condensateur de stockage ($C_4$) étant contiguë à la région de transfert (102), et les régions de condensateur ($C_4$, etc.) correspondant à une fil de bit (25) dans l'ensemble du dispositif étant disposées entre les régions de condensateur correspondant à un fil de bit voisin dudit fil de bit.

4. Dispositif de mémoire à semi-conducteur selon la revendiction 3, caractérisé en ce que, chaque paire de cellules de mèmoire comportant deux cellules de mémoire et étant connectée au fil de bit correspondant, la paire de cellules de mémoire comprenant:

— une région de contact commune (101);
— des première et seconde régions de transfert (102) placées des deux côtés respectifs de la région de contact (101);
— des première et seconde régions de condensateur ($C_4$, $C_5$) contiguës respectivement aux première et seconde régions de transfert (102); les paires de cellules de mémoire correspondant à un fil de bit sont voisines les unes des autres de deux fils de mot, et une première ou une seconde région de condensateur de la paire de cellules de mèmoire correspondant au fil de bit voisin dudit fil de bit est placée entre ses fils de mot qui sont placés respectivement dans les première et seconde régions de transfert de la paire de cellules de mémoire correspondant audit fil de bit.

5. Dispositif de mèmoire à semi-conducteur selon l'une quelconque des revendications 3 et 4, caractérisé en ce que la région de condensateur comprend:

— une région de diffusion (28) dans un substrat,
— une première couche d'électrode (22) connectée à la région de diffusion (28) et s'étendant par-dessus une couche isolante se trouvant sur la substrat, et
— une seconde cuche d'électrode (23) s'étendant par-dessus la première couche d'électrode (22) par l'intermédiaire d'une couche diélectrique.

6. Dispositif de mémoire à semi-conducteur selon la revendication 5, caractérisé en ce que:

— les secondes couches d'électrode (23) sont constituées par une couche conductrice commune s'étendant par-dessus le substrat, et en ce que la couche conductrice commune comprend un trou (27) dans une région de connexion à travers lequel le fil de bit (25) s'étendant par-dessus la couche conductrice commune est connecté à une région de diffusion (26) se trouvant dans le substrat de la région de connexion.

7. Dispositif de mémoire à semi-conducteur selon la revendication 6, caractérisé en ce que le fil de mot est placé au-dessous de la couche conductrice commune.

8. Dispositif de mémoire à semi-conducteur selon l'une quelconque des revendications 5 à 7, caractérisé en ce que: le substrat est constitué d'un semiconducteur monocristallin, le fil de mot et les première et seconde couches d'électrode sont constitués de silicium polycristallin, et le fill de bit est constitué de métal.

*Fig. 1*

*Fig. 2*

1

Fig. 3

Fig. 4

0 055 572

3

Fig. 7

Fig . 8

Fig . 9